Europäisches Patentamt

European Patent Office

Office européen des brevets

(11) Publication number: **0 183 742**
**B1**

(12) # EUROPEAN PATENT SPECIFICATION

(45) Date of publication of patent specification: **02.01.91**

(51) Int. Cl.⁵: **H 03 K 17/96**

(21) Application number: **85902491.1**

(22) Date of filing: **23.05.85**

(86) International application number:
**PCT/DK85/00049**

(87) International publication number:
**WO 85/05513 05.12.85 Gazette 85/26**

(54) **ELECTRONIC SWITCH.**

(30) Priority: **23.05.84 DK 2537/84**

(43) Date of publication of application:
**11.06.86 Bulletin 86/24**

(45) Publication of the grant of the patent:
**02.01.91 Bulletin 91/01**

(84) Designated Contracting States:
**AT BE CH DE FR GB IT LI LU NL SE**

(56) References cited:
**DE-C-3 029 717**
**US-A-3 621 307**
**US-A-3 766 404**

(73) Proprietor: **SJOBERG, Lars Ake**
**Dyrskuevej 29**
**Skalborg, DK-9200 Aalborg SV (DK)**

(72) Inventor: **SJOBERG, Lars Ake**
**Dyrskuevej 29**
**Skalborg, DK-9200 Aalborg SV (DK)**

(74) Representative: **Larsen, Hans Ole et al**
**Larsen & Birkeholm A/S Skagensgade 64**
**DK-2630 Taastrup (DK)**

Courier Press, Leamington Spa, England.

## Description

Switches, reacting to a light touch, have found a wide use connected with signal systems and electronic apparatus. Most of them work by direct pressure on a contact spring or on a flexible insulation plate covering the contact and may have an inscription, but it is also known to use electronic current circuits, which are effected by change of capacitance or by change of light reflection. A "touch" also can be a metal plate, the voltage of which is changed when it is touched, resulting in a change of the bias on a transistor electrode, as for example is disclosed in US Patent No. 3 766 404. One field of applications for such switches is learning apparatus and signal- and calling systems for disabled human beings, which only can move a few parts of the body, a thumb or the head.

None of the above—mentioned "touches" works satisfactory for this purpose. Solidity and simple handling for as well nursing staff as patient is a necessity and the "touch" must be unaffected by occasional changes of humidity, vibrations, capacitance to environment etc. In German Patent No. 3 029 717 is disclosed a touch contact with an oscillator, which when touching an electrode, which is connected to a frequency controlling L—C circuit, changes the amplitude of the oscillations. The oscillations are rectified and charge a capacitor, the voltage of which is used as a blocking voltage over a transistor comprising a relay in its current circuit. If the amplitude of the oscillations is decreased or if the oscillations come to an end, the voltage over said capacitor drops below the blocking level for the transistor, which becomes conductive, and the relay is activated. Of course such a touch contact works relatively independent of big or small size of the touching element, as well as interference fields, which are generated by electrical installations, cannot disturbe its function, less than that the interference field occasion has the same frequency as the oscillations. If this type of touching contact shall be sensitive, the attenuation of the oscillation circuit must be adjusted satisfactory, and then the risk of that the oscillator falls out by itself becomes rather big. In UA—A—3 621 307 a touch responsive control circuit is disclosed having a touch electrode and an astable amplifier which starts oscillation when, upon touching of the touch plate, the capacitive impedance of a human body is inserted into the feedback network. The present invention is based on a physiological phenomena, which makes it possible to distinguish between the influences of an elec- tronic touch contact, which depends on a non- controllable change of the physical conditions of the environment (e.g. interference fields, changes of humidity degree of the air, change of temperature, change of capacitance, vibrations etc.) and the direct contact between a touch electrode and an unisolated part of a human or animal body. It has been known for a long time that nerve or muscle stimuli is followed by electrical phenomena in form of voltage changes and weak electric currents. A detailed description of these phenomena can be found in "Introduction to Comperative Physiology" by Leon Goldstein, Brown University, 1977.

The outer potential changes which arise as a result of a nerve or muscle—fibres stimulus, are of the same magnitude as those which are caused by disturbance fields from electronic installation, $10^{-3}$ to $10^{-4}$ volt, and are therefore not immediately useful for initiate a touch on an electrode.

However the positive voltage pulse, i.e. the potential around the nerve cell, is short and is more negative than the resting potential. By the present invention it has been possible to use this phenomena as a unambiguous criterion of contacting an electrode by a finger or any other uninsulated part of a human or animal body.

The electronic switch according to the invention is of the kind described in said German patent, in which contacting an input electrode of an electronic circuit changes its condition so that a relay will be activated, or a signal is generated. The invention is characterised in that the electronic circuit comprises an astable amplifier circuit with an input filter which is short-circuited by positive voltage changes but not for negative voltage changes and the output of which is connected to an aerial for emitting of resulted oscillations.

In contrast to known electronic touch switches, which in their state of rest oscillate with a frequency resulting from a built-in oscillation circuit, the electronic switch according to the invention has no well-defined output voltage in the state of rest. In spite of the very high degree of amplification of the astable amplifier it does not react on disturbance fields from electrical or electronic apparatus. However when touching the input electrode with a part of a human body arises an oscillation condition in $MH_z$—range, which can be detected and activates a relay or generates a signal.

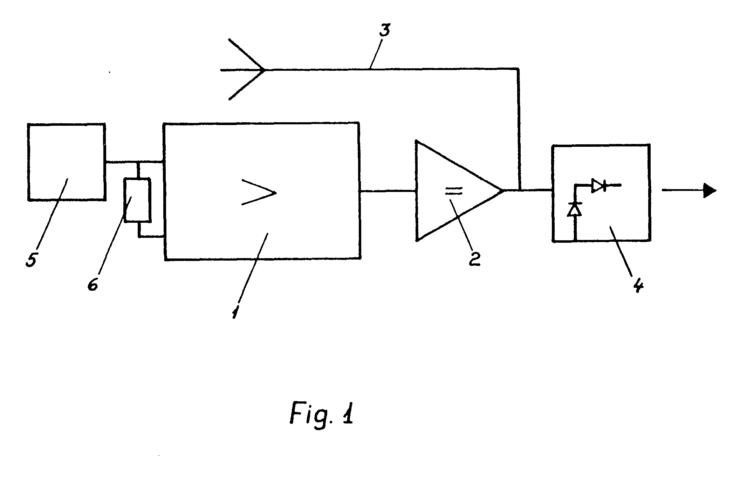

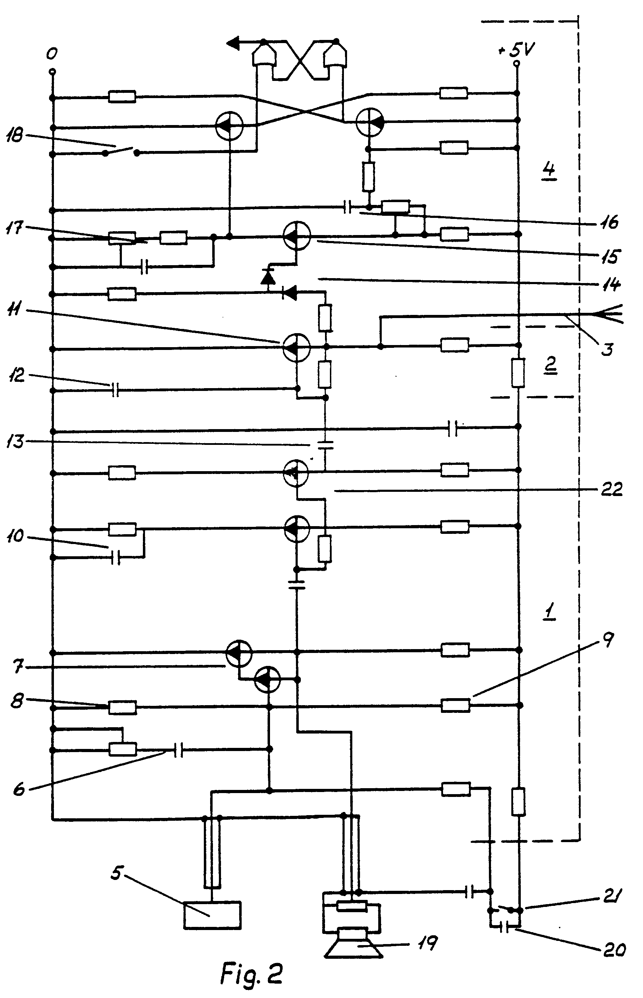

The function of the electronic switch will be described more in detail with reference to the accompanying drawing in which Fig. 1 shows a schematic arrangement according to the invention. Fig. 2 shows a more detailed embodiment of the invention.

In Fig. 1, 1 refers to an astable amplifier circuit and 2 refers to an amplifier which amplifies the output voltage of the generator before said output voltage is fed to an aerial 3 and an output stage 4 which converts a change of the output voltage from the generator to a current big enough to activate a relay or a signal lamp. A touch electrode 5, normally a metal plate big enough for a disabled human being to contact without trouble, is conductively connected to the input of the amplifier 1, which further is shunted by a special filter 6, which only permits negative transients to affect the amplifier. As later will be described such a filter can be made very simple. The filter 6 is quite necessary so that "touch" only reacts when touching with a finger or an other part of the body.

When the electrode 5 is untouched the voltage on the aerial is an undefined noise voltage. This condition is not changed by itself if strong interference sources, e.g. electric power lines or a television set, are placed close to the electrode 5. Only when the electrode 5 is directly touched by a part of a human body (or as said above by some part of any animal body) a pronounced change of the generator function takes place. Now the irregular noise voltage over the aerial is superimposed with a great pulsating voltage in the $MH_z$-range.

Since the effect does not occur unless the aerial is radiation coupled to the electrode 5, the obtained effect can only depend on that the touching part of the body is included in a feedback circuit between the input and output of the generator and as a result of that modulates said generator.

In Fig. 2 is shown a detailed diagram for an electronic switch according to the invention. The amplifier 1 includes two amplifier circuits, namely one modified Darlington-coupling 7, with directly connected collectors, resulting in that the voltage over the collectors is constant, and two in a DC-manner directly connected transistors 22. The filter 6 in Fig. 1 includes here a big electrolytic capacitor in series with a potentiometer. This series connection is shunted with a big resistor 8. The sensitivity of the "touch" can be adjusted by means of the potentiometer. A resistor 9 sees to that there is sufficient positive bias on the input electrode of the Darlington coupling, that negative impulses can be transferred.

An R—C filter 10 is inserted between the emitter of the first of the transistors 22 and the zero conductor.

The direct connection between the collector of the first transistor and the base of the second transistor in the pair of transistors 22 gives such a big amplification that the amplifier becomes astable. Signals from the pair of transistors 22 are via a capacitor 13 transmitted to the output amplifier 2 (the same as 2 in Fig. 1) consisting of one signal transistor 11 the emitter of which is directly connected to the zero conductor, while its base via a rather small capacitor 12 is connected to zero. This causes that a current through the transistor 11 with a frequency less than 50 $MH_z$ will negatively charge the coupling capacitor related to the zero conductor, which again causes the collector to the positive, since the transistor 11 is coupled as a direct current amplifier. As can be seen the aerial 3 is directly connected to the collector of the transistor 11. The output stage consists of a decoder and a traditional flip-flop circuit which can be obtained as integrated circuit element. The decoder includes a pair of diodes 14 and a transistor 15. The first diode gives a reference voltage of about 1 volt, which must be exceeded if the other diode will be opened for passage to the transistor 15, which again activates the flip-flop circuit. The above-mentioned explained function of the amplfier 2, that the positive voltage on the pair of diodes exceeds the theshold value if there is a signal, leads consequently to that the transistor 15 will be activated. In the collector circuit of the transistor 15 is inserted a delay chain, which causes an adjustable delay of the activation of the flip-flop circuit, and in the emitter circuit of said transistor is inserted a holding circuit 17, which holds the flip-flop circuit in its set condition for a time corresponding to the special use of the "touch". As shown a switch 18 can be inserted in the flip-flop circuit. When said switch is closed the flip-flop circuit remains in its set condition until the switch again is opened. The "touch" thereby can be used as an alarm switch. The above mentioned embodiment has the advantage that it can easily be combined with more traditional activation methods. For example it is possible to activate the "touch" with an ordinary "pressure on a button". This can be made by inserting a capacitor 20 over the input of the Darlington-coupling 7. This capacitor is normally charged, but can be short-circuited by a switch 21 and in that way be discharged. When the switch again is opened a negative impulse is sent to the Darlington-coupling, which thereby will be activated for a short time, but long enough for setting the flip-flop circuit. On the drawing is also shown the connection of a microphone direct to the pair of transistors 22. This is a practical detail, but not a part of the invention. The microphone ought to be selective to certain sound frequencies, for example to the dominant in the vocal "a".

The above menetioned arrangements make, as said, the invention electronic switch universal useful, but the essential thing with the invention is that it has been successful to manufacture a so called "touch", which can select the tremendous weak current impulses from stimulated nerve cells or muscle tissue and amplify them.

## Claims

1. An electronic switch comprising a touch-sensitive input electrode connected to an electronic circuit adapted to change its condition in response to the electrode being contacted, so as to produce an output to activate a relay and/or generate a signal; whereby said electronic circuit comprises an astable amplifier circuit (1) having an input connected to said electrode (5) such that an oscillating output signal is generated by said astable amplifier circuit (1) in response to a voltage signal received from said electrode (5); the input to said astable amplifier circuit (1) is shunted by a filter circuit (6) adapted to short-circuit positive voltage signals received from said electrode (5), but not negative voltage signals, such that the astable amplifier circuit (1) responds only to negative voltage signals characeristic of the touch of a finger or other part of a human or animal body; and the output from said astable amplifier circuit (1) is connected to an aerial (3) for radiation of said output signal, said aerial (3) being so positioned as to be radiation coupled to said electrode (5) such that said finger or the like is included in a feedback circuit between the aerial (3) and the electrode (5).

2. An electonic switch according to claim 1, wherein the filter (6) consists of a series connection of an electrolytic capacitor in series with a potentiometer, which series connection is shunted by a high resistance (8).

3. An electonic switch according to claim 1 or claim 2 wherein, between the aerial (3) and the output of the amplifier (1), is arranged an amplifier stage (2), which consists of a transistor (11) coupled as a direct current amplifier, and the input electrode of which is connected to earth via a small capacitance, while its gate electrode is directly connected to earth.

4. An electronic switch according to claim 1, claim 2 or claim 3, wherein a capacitor (20) is connected to the input of the astable amplifier circuit, which capacitor normally is positively charged relative to the input potential, said capacitor being shunted by a press button switch (21), which when closed discharges the capacitor and applies a positive voltage to the input of the astable amplifier circuit, and when subsequently opened applies a negative charge impulse thereto.

## Patentansprüche

1. Ein elektronischer Schalter, der eine berührungsempfindliche Eingangselektrode umfaßt, die mit einem elektronischen Schaltkreis verbunden ist, der dazu vorgesehen ist, seinen Zustand in Reaktion auf ein Berühren der Elektrode, zu verändern, um so einen Ausgangswert zur Aktivierung eines Relais oder/und eine Signal zu erzeugen; wobei der elektronische Schaltkreis einen astabilen Verstärkerschaltkreis (1) umfaßt, der einen Eingang aufweist, der mit der Elektrode (5) derart verbunden ist, daß eine oszillierendes Ausgangssignal durch den astabilen Verstärkerschaltkreis (1) in Reaktion auf ein Spannungssignal, das von der Elektrode (5) empfangen wird, erzeugt wird; dem Eingang des astabilen Verstärkerschaltkreises (1) ein Filterschaltkreis (6) parallel geschaltet ist, der dazu vorgesehen ist, positive Spannungssignale, die von der Elektrode (5) empfangen werden, kurzzuschließen, derart, daß der astabile Verstärkerschaltkreis (1) nur auf negative Spannungssignale, die für die Berührung eines Fingers oder eines anderen Teils eines menschlichen oder tierischen Körpers charakteristisch sind, reagiert, und wobei der Ausgang des astabilen Verstärkerschaltkreises (1) mit einer Antenne (3) zur Abstrahlung des Ausgangssignals verbunden und die Antenne (3) so angeordnet ist, daß sie' strahlungsgekoppelt mit der Elektrode (5) derart ist, daß der Finger oder dergleichen in einen Rückkopplungsschaltkreis zwischen der Antenne (3) und der Elektrode (5) eingeschlossen ist.

2. Ein elektronischer Schalter nach Anspruch 1, wobei der Filter (6) aus einer Reihenschaltung von einem Elektrolytkondensator in Reihe mit einem Potenionmeter besteht, wobei der Reihenschaltung ein hoher Widerstand (8) parallel geschaltet ist.

3. Ein elektronischer Schalter nach Anspruch 1 oder 2, wobei, zwischen der Antenne (3) und dem Ausgang des Verstärkers (1) eine Verstärkerstufe (2) angeordnet ist, welche aus einem Transistor (11) besteht, welcher als ein Direktstromverstärker angeschlossen ist und dessen Eingangselektrode über eine kleine Kapazität mit der Erde verbunden ist, während seine Gateelektrode direkt mit der Erde verbunden ist.

4. Ein elektronischer Schalter nach Anspruch 1, 2 oder 3, worin ein Kondensator (20) mit dem Eingang des astabilen Verstärkerschaltkreises verbunden ist, wobei der Kondensator normalerweise positiv relative zum Eingangspotential aufgeladen ist, und dem Kondensator ein Druckknopfschalter (21) parallel geschaltet ist, welcher, wenn er geschlossen ist, den Kondensator entlädt und eine positive Spannung an den Eingang des astabilen Verstärkerschaltkreises anlegt, und wenn er nachfolgend geöffnet wird, einen negativen Ladungsimpuls daran anlegt.

## Revendications

1. Commutateur électronique comportant une électrode d'entrée sensible connectée à un circuit électronique conçu pour modifier son état en réponse à un contact avec l'électrode, de manière à former une sortie destinée à actionner un relais et/ou à générer un signal; dans lequel ledit circuit électronique comporte un circuit amplificateur astable (1) ayant une entrée reliée à ladite électrode (5) de façon qu'on signal de sortie oscillant soit crée par ledit circuit amplificateur astable (1) en réponse à un signal de tension reçu de ladite électrode (5); l'entrée dudit circuit amplificateur astable (1) est shuntée par un circuit de filtrage (6) conçu pour court-circuiter des signaux de tension positive reçu de ladite électrode (5), mais non les signaux de tension négative, de telle sorte que le circuit amplificateur astable (1) répond uniquement aux signaux de tension négative caractéristiques du contact d'un doigt ou d'une autre partie du corps d'une personne ou d'un animal; et la sortie dudit circuit amplificateur astable (1) est connectée à un aérien (3) pour diffuser ledit signal de sortie, ledit aérien (3) étant placé de façon à être couplé par rayonnement à ladite électrode (5) de manière que ledit doigt ou analogue soit inclus dans un circuit de contre-réaction entre l'aérien (3) et l'électrode (5).

2. Commutateur électronique selon la revendication 1, dans lequel le filtre (6) comporte une connexion en série d'un condensateur électrolytique en série avec un potentiomètre, laquelle connexion en série est shuntée par une résistance élevée (8).

3. Commutateuer électronique selon la revendication 1 ou 2, dans lequel, entre l'aérien (3) et la sortie de l'amplificateur (1) est monté un étage amplificateur (2), qui comporte un transistor (11) monté en amplificateur à courant continu, et dont l'électrode d'entrée est connectée à la masse par l'intermédiaire d'une petite capacité, tandis que son électrode de gâchette est directement connectée à la masse.

4. Commutateur électronique selon les revendications 1, 2 ou 3, dans lequel un condensateur (20) est connecté à l'entrée du circuit amplificateur astable, lequel condensateur porte normalement une charge positive par rapport au potentiel d'entrée, ledit condensateur étant shunté par un interrupteur à bouton-poussoir (21) qui lorsqu'il est fermé décharge le condensateur et applique une tension positive à l'entrée du circuit amplificateur astable, et lorsqu'il est ensuite ouvert applique une impulsion de charge négative à ce circuit.

*Fig. 1*

Fig. 2